# EUROPEAN PATENT SPECIFICATION

(11) **EP 2 060 792 B1**
(45) Date of publication and mention of the grant of the patent: **26.05.2010**
(21) Application number: 07120950.6
(22) Date of filing: 19.11.2007
(51) Int. Cl.: F04D 3/02, H01L 37/04

(54) **Combined pump and valve apparatus**
Kombinierte Pumpen- und Ventilvorrichtung
Appareil combiné de pompe et vanne

(43) Date of publication of application: 20.05.2009
(73) Proprietor: Abb Research, 8050 Zürich (CH)
(72) Inventor: Russberg, Gunnar, 724 62 Västerås (SE); Thorburn, Stefan, 723 48 Västerås (SE); Rothman, Bengt, 723 36 Västerås (SE)
(74) Representative: Dahlstrand, Björn

(56) References cited:
- EP-A- 0 615 100
- FR-A- 2 187 030
- FR-A- 2 315 021
- SOLOMON D: "DESIGN OF A THERMOMAGNETIC GENERATOR" ENERGY CONVERSION AND MANAGEMENT, ELSEVIER SCIENCE PUBLISHERS, OXFORD, GB, vol. 31, no. 2, 1 January 1991 (1991-01-01), pages 157-173, XP000177184 ISSN: 0196-8904

## Description

### TECHNICAL FIELD OF THE INVENTION

The present invention generally relates to pump and valve assemblies. The invention is preferably, but not exclusively, intended for a generator system for converting thermal energy to electric energy.

### DESCRIPTION OF RELATED ART AND BACKGROUND OF THE INVENTION

In known generator systems for converting thermal energy to electric energy there is provided a magnetic circuit of a suitable magnetic material and a coil arranged around the magnetic circuit. A temperature-varying arrangement varies the temperature of the magnetic circuit alternately above and below a phase transition temperature such as the Curie point to thereby vary the reluctance of the magnetic circuit and the resulting magnetization of the magnetic circuit is modulated by the varying reluctance so as to induce electric energy in the coil arranged around the magnetic circuit. The temperature-varying arrangement passes alternately hot and cold fluid by the magnetic circuit and comprises typically one or several feed pumps, piping, and a valve manifold. A problem of such arrangement is that energetically inefficient cycling of fluid is achieved, and the arrangement tends to become complex.

FR 2187030, which is considered as the prior art to the subject-matter of claim 1, describes a pump without rotating parts and bearings, which however does not comprise a shaft and a plurality of outlets or inlets fixedly arranged along the circumference of the casing.

### SUMMARY OF THE INVENTION

It is therefore an object of the present invention to provide a combined pump and valve apparatus, which has a simplified, yet improved, structure and operation.

It is a particular object of the invention to provide such a combined pump and valve apparatus, which can provide for a smooth and energetically efficient cycling of fluid.

It is still a further object of the invention to provide such a combined pump and valve apparatus, which are dynamically controllable, reliable, flexible, and of reasonable cost.

It is yet a further object of the invention to provide such a combined pump and valve apparatus, which can be used in a temperature-varying arrangement for a generator system that converts thermal energy to electric energy.

These objects, among others, are according to the present invention attained by combined pump and valve apparatuses as specified in the appended patent claims.

According to one aspect of the invention there is provided a combined pump and valve apparatus, which includes a cylindrical casing, a shaft arranged symmetrically in the casing, a device fixedly attached to the shaft and in close fit with the cylindrical casing to thereby define separated chambers within the casing, a plurality of outlets/inlets fixedly arranged along the circumference of the casing, and a plurality of axially arranged inlets/outlets, each of which being fixedly connected to a respective one of the separated chambers. The separated chambers and thereby the axially arranged inlets/outlets are alternately in fluid connection with each of the outlets/inlets fixedly arranged along the circumference of the casing in response to rotation of the shaft and the device with respect to the casing. Further, the device comprises an impeller arrangement for pumping a fluid through the combined pump and valve apparatus in response to rotation of the shaft and the device.

In one embodiment of the invention the device comprises a member in the close fit with the cylindrical casing, which defines the separated chambers within the casing, and the impeller arrangement as separated parts. Advantageously, the impeller arrangement comprises two impellers, one at each side of the member as seen in the axial direction.

In another embodiment of the invention the device is a single-piece device, which advantageously comprises surfaces that are shaped to obtain impelling function while the single-piece device is rotated. That is, the single-piece device, which is in close fit with the casing and defines the separated chambers within the casing, has suitably shaped surfaces in the two axial directions to resemble the operation of the two impellers of the previous embodiment. Thus, two different functions (chamber dividing function and impelling function) are achieved by a single component.

The present invention features a combined pump and valve apparatus, which is simple, reliable, and robust, and by which smooth and energetically efficient pumping and distribution of fluids, can be made.

The combined pump and valve apparatus of the present invention can be used for the thermal cycling of fluid in a thermomagnetic generator device, but can alternatively be used in entirely different applications, in which fluids of different characteristics should be alternately output in a single pipe.

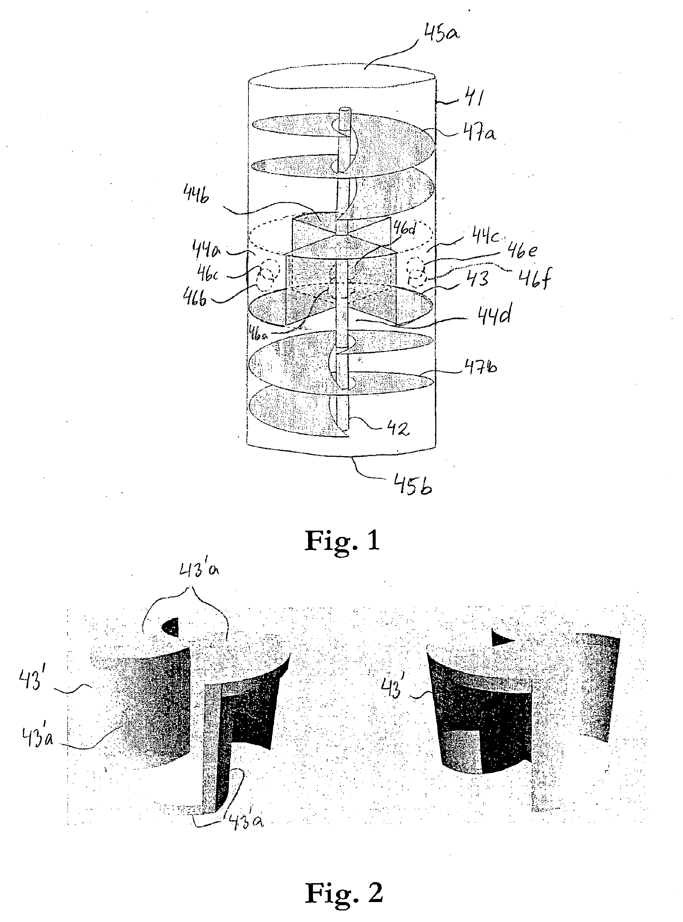

Further characteristics of the invention and advantages thereof, will be evident from the following detailed description of preferred embodiments of the present invention given hereinafter and the accompanying Figs. 1-7, which are given by way of illustration only and thus, are not limitative of the present invention.

### BRIEF DESCRIPTION OF THE DRAWINGS

Fig. 1 displays schematically in a perspective view a combined pump and valve apparatus according to an embodiment of the invention.
Figs. 2 and 3 display schematically in perspective views examples of devices that can be used in the apparatus of Fig. 1.
Figs. 4 and 5 display each schematically in a perspective view a combined pump and valve apparatus according to a further embodiment of the invention.
Figs. 6 and 7 display schematically thermomagnetic generator systems comprising combined pump and valve apparatuses of the present invention.

### DETAILED DESCRIPTION OF EMBODIMENTS

A combined pump and valve apparatus according to an embodiment of the invention is disclosed in Fig. 1. A hollow cylinder or cylindrical casing 41 houses a symmetrically arranged rotatable shaft 42, to which a member 43 is fixedly attached. The member 43, which preferably is thermally isolating, is provided in close fit with the cylindrical casing 41 and defines four essentially separated and identical compartments or chambers 44a-d of the apparatus. Each of the chambers 44a-d is defined by two sidewalls that extends radially from the shaft 42 and to the casing 1 and axially, and a top cover that extends radially from the shaft 42 and to the casing 1 and circumferentially between the two sidewalls. Two of the chambers 44a, 44c are fixedly connected to a first axially arranged inlet or outlet 45a, and is configured to receive or output fluid of a first characteristic, and two of the chambers 44b, 44d are fixedly connected to a second axially arranged inlet or outlet 45b, and is configured to receive or output fluid of a second characteristic.

Further, a number of outlets or inlets 46a-f are arranged circumferentially in the casing 41, preferably with equal distances between one another. The circumferentially arranged outlets or inlets 46a-f can alternately be put in fluid communication with the respective chambers 44a-d by rotating the shaft 42 and the member 43, thereby also rotating the chambers 44a-d.

Yet further, an impeller arrangement 47a-b is fixedly mounted onto the shaft 42 within the casing for pumping at least one fluid through the combined pump and valve apparatus in response to rotation of the shaft 42. Preferably the impeller arrangement comprises two separate impellers 47a-b, one at each side of the member 43 as seen in the axial direction. The structure of the impellers may be of any suitable kind to obtain a suitable pumping operation for the application in question.

The shaft 42 is advantageously mounted in the cylindrical casing 41 by means of bearings and means, e.g. an electric motor (not illustrated), is provided to apply a driving torque on the shaft 42.

During operation of the combined pump and valve apparatus in a first operation mode, the shaft 42 and thereby the member 43 and the impeller arrangement 47a-b are steadily rotated with respect to the casing 41 and the outlets 46a-f by means of the motor, thereby sucking a fluid of a first characteristic trough the first axially arranged inlet or outlet 45a and into the two chambers 44a, 44c fixedly connected to the first axially arranged inlet or outlet 45a, and sucking a fluid of a second characteristic trough the second axially arranged inlet or outlet 45b and into the two chambers 44b, 44d fixedly connected to the second axially arranged inlet or outlet 45b. Thus, the axially arranged inlets or outlets 45a-b are in this operation mode inlets. As the member 43 and thus the chambers 44a-d thereof are rotated with respect to the casing the fluids of the first and second characteristics are alternately output through the circumferentially arranged outlets or inlets 46a-f, which thus in this operation mode are outlets.

The circumferentially arranged outlets 46a-f alternately output pulses of fluids of the first and second characteristics. The rotational speed for a given number of chambers controls the wavelength and frequency of the train of fluid pulses and the angular separation of the outlets controls the phase shift between them.

The fluids of the first and second characteristics may be fluids, such as e.g. water or other heat exchange fluid, of different temperatures. Alternatively, different fluids or fluids having different properties are mixed by the combined pump and valve apparatus.

In a second operation mode the combined pump and valve apparatus operates in a reciprocal manner to divide up fluid pulses of the first and second characteristics received at the circumferentially arranged outlets or inlets 46a-f, being inlets in this operation mode. The shaft 42 and thereby the member 43 and the impeller arrangement 47a-b are steadily rotated in the opposite direction with respect to the casing 41 and the outlets 46a-f by means of the motor. Hereby, the fluid pulses of the first and second characteristic are sucked through the circumferentially arranged inlets 46a-f and alternately into the respective chambers 44a-d of the casing 41. The fluid pulses that are collected in the two chambers 44a, 44c fixedly connected to the first axially arranged inlet or outlet 45a is output there through, and the fluid pulses that are collected in the two chambers 44b, 44d fixedly connected to the second axially arranged inlet or outlet 45b is output there through. Thus, the axially arranged inlets or outlets 45a-b are outlets in this operation mode. If the rotational speed of the shaft 42 is adapted to the frequency of the fluid pulses and the phase shift between the fluid pulses at the circumferentially arranged inlets 46a-f is adapted to the angular separation of the circumferentially arranged inlets 46a-f fluid of the first characteristic can be collected by the combined pump and valve apparatus and output though the first axially arranged outlet 45a and fluid of the second characteristic can be collected by the combined pump and valve apparatus and output though the second axially arranged outlet 45b.

A small separation between the member 43 and the wall of the cylindrical casing 41 may be allowed, reducing or eliminating solid-to-solid contact forces with only negligible amounts of fluid being mixed.

The combined pump and valve apparatus is capable of distributing industrial scale amounts of fluids with different characteristics to a common outlet (or several common outlets) with minimal mixing on a sub-second scale. The combined pump and valve apparatus allows for a steady fluid flow with minimal disturbance from switching, minimal switching power demand, and a long lifetime with the ability to switch millions of cycles.

Conventional valves and piston pumps either are too slow, too disruptive (flow stop, pressure waves), power demanding and/or wear out after rather short a number of cycles.

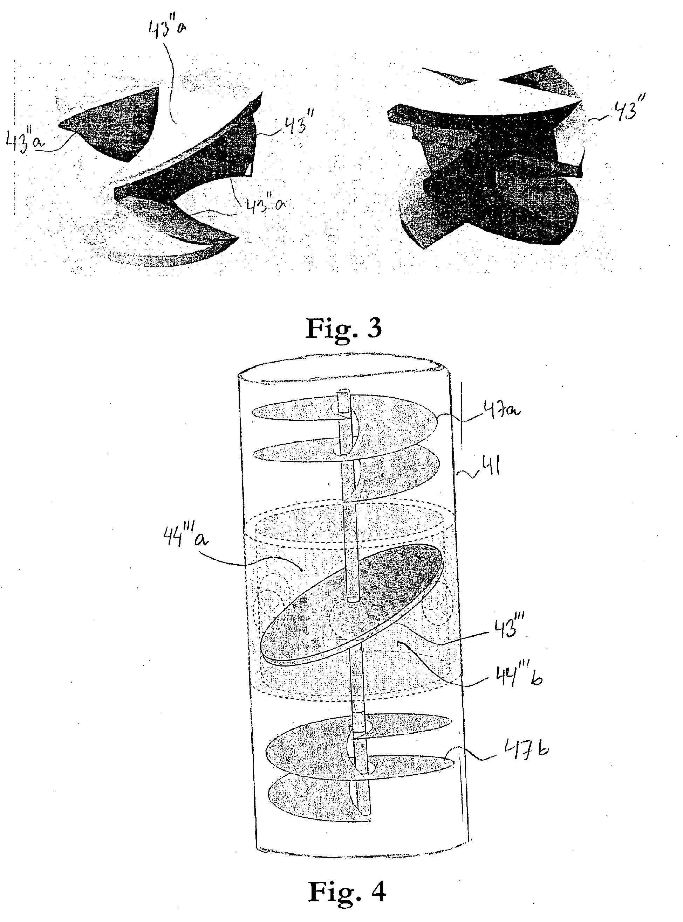

Figs. 2 and 3 display each schematically in a perspective view a chamber-dividing member 43' (fig. 2) and 43" (Fig. 3) comprising an impeller arrangement integrated therein, which can be used in the apparatus of Fig. 1 instead of the member 43 and the impeller arrangement 47a-b. Each of the Figures discloses the chamber-dividing member in two different views. The impelling arrangement is provided as surface portions 43'a, 43 " a of the member 43', 43" that are shaped to obtain impelling function while the member 43', 43" is rotated. The chamber-dividing member and the impeller arrangement are here thus integrated into a single-piece part or body, which provides the chamber-dividing and rotating function and the impelling function for flows in both axial directions.

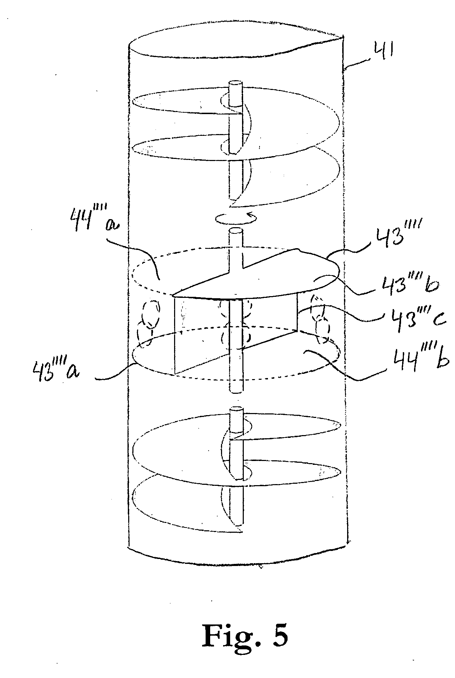

With reference next to Fig. 5, a combined pump and valve apparatus according to a further embodiment of the invention differs from the embodiment of Fig. 1 in that the chamber-dividing and rotating member 43 is exchanged for an elliptic disc 43''' fixedly mounted on the shaft in an inclined position. The elliptic disc 43''' is arranged in close fit with the cylindrical casing 41, to define a first and a second chamber 44'''a-b. The elliptic disc 43' is arranged at an axial position and with an inclination angle such that each of the outlets/inlets at the circumference of the cylindrical casing 41 is alternately in fluid connection with the first and second chambers 44'''a-b as the shaft 42 and the elliptic disc 43''' are rotated with respect to the cylindrical casing 41.

The elliptic plate might be fabricated by cutting it from a predrilled solid cylinder having a diameter slightly less than the inner diameter of the cylindrical casing.

A large number of circumferentially arranged outlets/inlets minimize possible pressure variations associated with the elliptic disc 43''' sweeping by a circumferentially arranged outlet/inlet. During the peak of such an event the elliptic disc 43''' may, depending on the actual design chosen, cover either the full outlet/inlet area (some unsteadiness has be tolerated in the outlet/inlet flow) or only part of it (some mixing has to be tolerated in the outlet/inlet flow).

The elliptic disc 43' may be suitable reshaped, e.g. by means of bulging, bending, and/or twisting, thereby requiring a shape other than elliptical, and be made thicker or unevenly thick to obtain an impeller arrangement at the surface portions thereof, e.g. similar to the member 43' and 43'' of Figs. 2-3, thereby rendering the separate impeller arrangement 47a-b unnecessary.

Since the embodiment of Fig. 4 comprises only two chambers 44'''a-b, the frequency of the output pulses will be half of the frequency of the fluid pulses produced by the embodiment of Fig. 1.

Fig. 5 illustrates a combined pump and valve apparatus according to yet further embodiment of the invention. This embodiment differs from the embodiment of Fig. 1 in that the member 43 is exchanged for another member 43'''' , which defines only two chambers 44'''' a-b. The member 43'''', which is fixedly mounted at the shaft 42, has two end portions 43''''a-b covering each essentially a respective half of the cross section of the casing 41 and an intermediate portion 43''''c separating the two end portions axially.

This member 43'''' may also be suitably reshaped so that an impeller arrangement is achieved by the surface portions thereof thereby rendering the separate impeller arrangement 47a-b unnecessary.

The combined pump and valve apparatus of the invention is applicable for industrial processes which involve alternating distribution of fluid with different characteristics into a common outlet, keeping the fluids separated with minimal mixing at a rate of a few cycles per second, continuously for e.g. several years. The fluids have preferably roughly similar fluid properties concerning e.g. density, viscosity, etc. They may consist of different substances, like water and ethanol, or of the same substance in different property states, like hot and cold water.

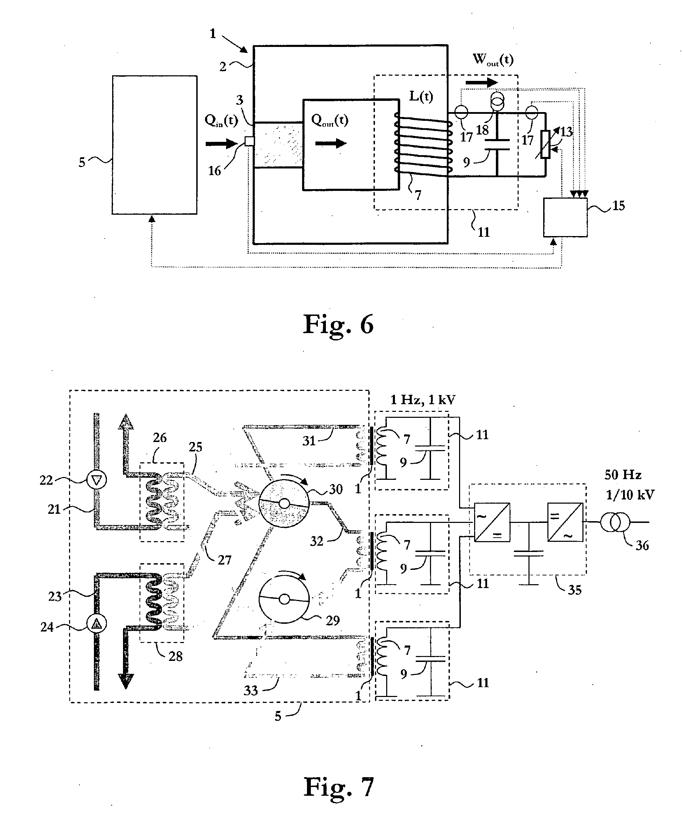

Particularly, the combined pump and valve apparatus of the invention can be applied in a thermomagnetic or magnetothermal generator system of an electric power plant. Such thermomagnetic or magnetothermal generator device for direct transformation of heat into electric energy comprises, as shown in Fig. 6, a magnetic ring or circuit 1, a temperature-varying device 5, and a coil or winding 7 arranged around the magnetic circuit 1.

The magnetic circuit may be substantially of iron or other magnetic material 2, but includes at least a portion 3 made of a magnetic material, which has a suitable phase transition temperature, e.g. in the interval 0-100 °C. Alternatively, an essential portion of the magnetic circuit or the entire circuit is of the magnetic material with the suitable phase transition temperature.

The temperature-varying device 5 is provided for varying the temperature in the portion made of the magnetic material with the suitable phase transition temperature alternately above and below a magnetic phase transition temperature of the magnetic material preferably with a frequency of about or above 1 Hz. Examples of magnetic phase transition temperatures are the Curie temperature and the Néel temperature. The temperature-varying device 5 comprises preferably a fluid loop including a source of heat, a source of cold, piping and at least two of the combined pump and valve apparatuses of the present invention.

The rapid variation of temperature above and below the phase transition temperature causes drastic changes of the permeability of the magnetic material and thus a rapid variation of the magnetic resistance or reluctance of the magnetic circuit 1. More concretely, the magnetization is varied rapidly when a constant magnetic field is applied.

Provided that a magnetic flux is provided in the magnetic circuit 1, the rapid variation of the reluctance will modulate the magnetic flux, thereby obtaining a rapidly varying magnetic flux in the magnetic circuit 1. As a result a magnetomotive force and an alternating current are obtained in the coil 7. The magnetic flux can be provided by a permanent magnet or, as in Fig. 1, by an electromagnet.

The current for the electromagnet is advantageously taken from the current induced in the coil. To this end, a capacitor 9 is connected in parallel with the coil 7 to thereby form a resonant electric circuit 11, wherein the frequency of the temperature variation above and below the phase transition temperature of the magnetic material is adjusted to optimize the resonant energy transfer to the resonant electric circuit 11. Advantageously, the ratio of the resonance frequency of the resonant electric circuit 11 and the frequency of the temperature variation above and below the phase transition temperature of the magnetic material is approximately 1/2 or n/2, where n is a positive integer.

Thus, a single coil will be used for the transformation of heat to electric energy and for providing a magnetic flux in the magnetic circuit 1. Such fields of alternating directions provides for a more cost efficient apparatus.

A part, e.g. a major part, of the current/charge induced in one half of a first thermal cycle is stored by the capacitor 9 and is used in the following half of the first thermal cycle to generate a magnetic flux in the magnetic circuit 1. This first thermal cycle corresponds to one half of an electric cycle. The procedure is repeated through a second thermal cycle with current and voltage 180 degrees phase shifted.

In order to be capable of controlling the resonance frequency, and the reactance of the electric circuit formed by the coil 7 and the capacitor 9, a fully controllable load or power electronic circuit device 13 is connected over the capacitor 9. Preferably, the load has an inductive component/capacitive component and a resistive component, each of which being separately and individually controllable. Advantageously, the load can be used to adjust the active power. A suitable control device 15 is provided for controlling the load 13. Different measurement devices, such as a thermo sensor 16, current transformers 17, and a voltage transformer 18 may be provided to supply the control device 15 with suitable measurement data. The thermo sensor 16 may supply the control device 15 with temperature data instantaneously measured in or at the magnetic material with the suitable phase transition temperature or in or at the temperature-varying device 5. The transformers 17, 18 may supply the control device 15 with voltage and current data instantaneously measured in the resonant electric circuit 11.

Hereby, the amplitude and phase of the impedance of the load can be dynamically controlled. The frequency and period of a variation of the impedance is controllable, and so is the frequency and period of the resonance of the resonant circuit 11. Further, the control device 15 may be configured to control the amplitude and frequency of the rapid variation of the temperature above and below the phase transition temperature.

Still further, the control device 15 may be provided to initiate the operation of the generator device, i.e. to start the resonant oscillations, e.g. by delivering a current pulse to the magnetic circuit 1.

With reference finally to Fig. 7, a multiphase thermomagnetic generator device will be described. Three only schematically indicated magnetic circuits 1 are provided, each of which being of the kind described with reference to Fig. 6 and each of which being operatively connected to a respective LC circuit 11 including a winding or coil 7 and a capacitor 9 connected in parallel. The resonance frequency each of the LC circuits 11 is as before essentially similar to the frequency of the temperature variation as created by the temperature-varying device 5. The multiphase generator device comprises further advantageously a power conversion device connected to the capacitors 9 of the three generator units or phases at the output. The coils 7 and the power conversion device are controlled to match the cycle of the thermal variation and to thereby enable optimum energy to be tapped from the circuit. The power conversion device may comprise an AC/DC or AC/AC frequency converter or a power electronic converter including a current or voltage source converter 36, which encompasses a rectifier and an inverter at the DC side of the rectifier. A transformer 37 is connected to the output of the voltage source converter 36 to transform the output voltage and frequency of about 1 kV and 1 Hz from the multiphase generator to a frequency and a voltage (50 Hz, 10 kV) suitable for normal grid connection. The rating of the equipment is typically larger than 1 kW.

The temperature-varying device 5 comprises an outer part, which includes a first external pipe arrangement 21, in which hot fluid is circulated by a feed pump 22, and a second external pipe arrangement 23, in which cold fluid is circulated by a feed pump 24. The hot and cold fluids of the outer part are entirely isolated from each other as well as from the material of the magnetic circuits 1.

The hot fluid in the first external pipe arrangement 21 transfers heat to fluid in a first intermediate pipe arrangement 25 via a first heat exchanger 26 and the cold fluid in the second external pipe arrangement 23 transfers cold to fluid in a second intermediate pipe arrangement 27 via a second heat exchanger 28. Each of the first and second intermediate pipe arrangements 25, 27 is connected between axial inlets/outlets of a first combined pump and valve apparatus 29 of the present invention and axial inlets/outlets of a second combined pump and valve apparatus 30 of the present invention to transport fluid from the first combined pump and valve apparatus 29 to the second combined pump and valve apparatus 30. Note that the combined pump and valve apparatuses of Figs. 1, 4, and 5 can be used; however the number of circumferentially arranged outlets/inlets has to be adapted to this application.

It shall be appreciated that the outer part may be exchanged for any other kind of arrangement for transferring heat and cold in the heat exchangers 26 and 28. For instance, heat may be transferred to fluid in the first intermediate pipe arrangement 25 in the first heat exchanger 26 via an incinerator, hot sand, a solar heating panel, or similar.

Finally, a first 31, a second 32, and a third internal pipe arrangement are each connected between the second combined pump and valve apparatus 30 and the first combined pump and valve apparatus 29 via a respective one of the magnetic circuits 1.

A single fluid is flowing in the inner part of the temperature-varying device 5, which comprises the intermediate and internal pipe arrangements and the first and second combined pump and valve apparatuses. The inner part thus provides a closed fluid loop.

The second combined pump and valve apparatus 30 is provided for alternately switching hot fluid from the first intermediate pipe arrangement 25 and cold fluid from the second intermediate pipe arrangement 27 into each one of the first, second and third internal pipe arrangements 31, 32, 33, preferably with a 120° phase shift there in between. Thus, the second combined pump and valve apparatus 30 "chops" the hot and cold fluids and forms trains of alternating hot and cold fluid pulses, which are fed into each of the internal pipe arrangements. The second combined pump and valve apparatus 30 thus operates in the first mode of operation as described with reference to Fig. 1.

As the hot and cold fluid pulses pass by, or through holes in, a magnetic material of the magnetic circuits 1, the magnetic material will be alternately heated above and cooled below the phase transition temperature as was described above in connection with the embodiment of Fig. 1. The terms "hot fluid" and "cold fluid" are here intended to indicate "fluid having a temperature above the phase transition temperature of the magnetic material of the portion 3 of the magnetic circuit" and "fluid having a temperature below the phase transition temperature of the magnetic material of the portion 3 of the magnetic circuit", respectively.

After having passed the magnetic material the temperature variation between the hot and cold fluid pulses is smaller and smoother. The trains of hot and cold fluid pulses are then returned in the respective internal pipe arrangements 31, 32, 33 to the first.combined pump and valve apparatus 29, which is synchronized with the trains of hot and cold fluid pulses. The first combined pump and valve apparatus 29 is provided for alternately switching the hotter fluid pulses from the first, second and third internal pipe arrangements 31, 32, 33 into the first intermediate pipe arrangement 25 and the colder fluid pulses from the first, second and third internal pipe arrangements 31, 32, 33 into the second intermediate pipe arrangement 27. Hereby, the hotter and colder fluid pulses are returned to the respective intermediate pipe arrangement, from which they were originating. The first combined pump and valve apparatus 29 thus operates in the second mode of operation as described with reference to Fig. 1.

The fluid in the first intermediate pipe arrangement 25 is then returned to the first heat exchanger 26 in order to be heated again and the fluid in the second intermediate pipe arrangement 27 is then returned to the second heat exchanger 28 in order to be cooled again.

The fluid in the inner part is driven in a single direction by the impeller arrangements integrated into the combined pump and valve apparatuses. The combined pump and valve apparatuses 29, 30 of Fig. 7 can be mounted on a single shaft to be rotated simultaneously/synchronously with a suitable phase shift there in between.

In an alternative version, particularly where the temperature difference between the hotter and colder fluid pulses is low, the hotter and colder fluid pulses from the first, second and third internal pipe arrangements may not have to be switched back into the second and first intermediate pipe arrangements. Thus, the first combined pump and valve apparatus 29 may be dispensed with, and another kind of passive distribution or mixing arrangement may be used instead in order to return the fluids to the second and first intermediate pipe arrangements. If an open circuit is used the fluids do not have to be returned.

By the temperature-varying device 5 as being described above with reference to Fig. 7, thermal cycling in a quasi-continuous or continuous manner is enabled. By means of having the fluid to circulate in a uni-directional closed loop the traditional disruptive and energetically inefficient cycling using valves switching on and off the fluid flow is entirely avoided.

## Claims

1. A combined pump and valve apparatus comprising:
- a cylindrical casing (41);
- a shaft (42) arranged symmetrically in said casing;
- a device (43, 47a-b, 43', 43'') fixedly attached to said shaft and in close fit with said cylindrical casing, thereby defining separated chambers (44a-d) within the casing;
- a plurality of outlets or inlets (46a-f) fixedly arranged along the circumference of said casing; and
- a plurality of axially arranged inlets or outlets (45a-b), each of which being fixedly connected to a respective one of said separated chambers, wherein
- the separated chambers and thereby the axially arranged inlets or outlets are alternately in fluid connection with each of the outlets or inlets fixedly arranged along the circumference of said casing in response to rotation of said shaft and said device with respect to said casting,
said device comprising an impeller arrangement (47a-b, 43', 43'') for pumping a fluid through said combined pump and valve apparatus in response to rotation of said shaft and said device.

2. The apparatus of claim 1 wherein said device fixedly attached to said shaft and in close fit with said cylindrical casing defines two separated chambers (44'''a-b, 44'''a-b) within the casing.

3. The apparatus of claim 2 wherein said device fixedly attached to said shaft and in close fit with said cylindrical casing comprises an elliptic disc (43''').

4. The apparatus of claim 2 wherein said device fixedly attached to said shaft and in close fit with said cylindrical casing comprises a member (43'''') having two end portions (43''''a-b) covering each essentially a respective half of the cross section of the casing and an intermediate portion separating the two end portions axially.

5. the apparatus of claim 1 wherein said device (43, 47a-b) fixedly attached to said shaft and in close fit with said cylindrical casing defines at least four separated chambers within the casing.

6. The apparatus of claim 5 wherein said device fixedly attached to said shaft and in close fit with said cylindrical casing comprises a member (43) that fixedly connects each one of the at least four separated chambers alternately to a respective one of the plurality of axially arranged inlets or outlets.

7. The apparatus of any of claims 1-6 wherein the number of said plurality of axially arranged inlets or outlets (45a-b) is two.

8. The apparatus of any of claims 1-7 wherein said device comprises a member (43) in said close fit with said cylindrical casing, thereby defining said separated chambers within the casing, and said impeller arrangement (47a-b) as separated parts.

9. The apparatus of claim 8 wherein said impeller arrangement comprises two impellers, one at each side of said member as seen in an axial direction.

10. The apparatus of any of claims 1-9 wherein said device is a single-piece device (43', 43'').

11. The apparatus of claim 10 wherein said single-piece device comprises surfaces (43'a, 43''a) that are shaped to obtain impelling function while said single-piece device is rotated.

12. The apparatus of any of claims 1-11 comprising a motor connected to said shaft and provided for rotating said shaft and said device.

13. A generator system for converting thermal energy to electric energy comprising the apparatus of any of claims 1-12.

14. An electric power plant comprising the generator system of claim 13.

15. Use of the apparatus of any of claims 1-12 in a method or system for producing electric power.

## Patentansprüche

1. Eine kombinierte Pump- und Ventilvorrichtung, umfassend:
- ein zylindrisches Gehäuse (41);
- eine Achse (42), die symmetrisch in dem Gehäuse angeordnet ist;
- ein Gerät (43, 47a-b, 43', 43 "), das fest an der Achse angebracht und in enger Passung mit dem zylindrischen Gehäuse ist, wodurch es separate Kammern (44a-d) innerhalb des Gehäuses definiert;
- eine Vielzahl von Auslässen oder Einlässen (46a-f), die fest entlang des Umfangs des Gehäuses angeordnet sind; und
- eine Vielzahl von axial angeordneten Einlässen oder Auslässen (45a-b), von denen jeder fest mit einer jeweiligen Kammer der separaten Kammern verbunden ist, wobei
- die separaten Kammern und **dadurch** die axial angeordneten Einlässe oder Auslässe abwechselnd in Fluidverbindung mit jedem der Auslässe oder Einlässe sind, die entlang des Umfangs des Gehäuses fest angeordnet sind, in Antwort auf Rotation der Achse und des Geräts bezüglich des Gehäuses,
wobei das Gerät eine Impelleranordnung (47a-b, 43', 43 ") umfasst zum Pumpen eines Fluids durch die kombinierte Pump- und Ventilvorrichtung in Antwort auf Rotation der Achse und des Geräts.

2. Die Vorrichtung nach Anspruch 1, wobei das Gerät, das fest an der Achse angebracht und in enger Passung mit dem zylindrischen Gehäuse ist, zwei separate Kammern (44'''a-b, 44'''a-b) innerhalb des Gehäuses definiert.

3. Die Vorrichtung nach Anspruch 2, wobei das Gerät, das fest an der Achse angebracht und in enger Passung mit dem zylindrischen Gehäuse ist, eine elliptische Scheibe (43''') umfasst.

4. Die Vorrichtung nach Anspruch 2, wobei das Gerät, das fest an der Achse angebracht und in enger Passung mit dem zylindrischen Gehäuse ist, ein Element (43'''') umfasst, das zwei Endteile (43''''a-b) hat, von denen jeder im Wesentlichen eine jeweilige Hälfte des Querschnitts des Gehäuses überdeckt, und einen Zwischenteil, der die zwei Endteile axial separiert.

5. Die Vorrichtung nach Anspruch 1, wobei das Gerät (43, 47a-b), das fest an der Achse angebracht und in enger Passung mit dem zylindrischen Gehäuse ist, mindestens vier separate Kammern innerhalb des Gehäuses definiert.

6. Die Vorrichtung nach Anspruch 5, wobei das Gerät, das fest an der Achse angebracht und in enger Passung mit dem zylindrischen Gehäuse ist, ein Element (43) umfasst, das eine jede der mindestens vier separaten Kammern abwechselnd mit jeweils einem Einlass oder Auslass aus der Vielzahl von axial angeordneten Einlässen oder Auslässen fest verbindet.

7. Die Vorrichtung nach einem der Ansprüche 1-6, wobei die Anzahl der Vielzahl von axial angeordneten Einlässen oder Auslässen (45a-b) zwei ist.

8. Die Vorrichtung nach einem der Ansprüche 1-7, wobei das Gerät als separate Teile ein Element (43) in der engen Passung mit dem zylindrischen Gehäuse, wodurch es die separaten Kammern innerhalb des Gehäuses definiert, und die Impelleranordnung (47a-b) umfasst.

9. Die Vorrichtung nach Anspruch 8, wobei die Impelleranordnung zwei Impeller umfasst, einen auf jeder Seite des Elements in axialer Blickrichtung.

10. Die Vorrichtung nach einem der Ansprüche 1-9, wobei das Gerät ein einstückiges Gerät (43', 43 ") ist.

11. Die Vorrichtung nach Anspruch 10, wobei das einstückige Gerät Oberflächen (43'a, 43''a) umfasst, die geformt sind, um eine Antriebsfunktion zu erhalten, während das einstückige Gerät rotiert wird.

12. Die Vorrichtung nach einem der Ansprüche 1-11, die einen Motor umfasst, der mit der Achse verbunden ist und zum Rotieren der Achse und des Geräts vorgesehen ist.

13. Ein Generatorsystem zum Konvertieren von thermischer Energie in elektrische Energie, umfassend die Vorrichtung nach einem der Ansprüche 1-12.

14. Ein Elektrizitätskraftwerk umfassend das Generatorsystem nach Anspruch 13.

15. Verwendung einer Vorrichtung nach einem der Ansprüche 1-12 in einem Verfahren oder System zur Erzeugung elektrischer Energie.

## Revendications

1. Dispositif de pompe et de vanne combinées comprenant :
- un carter cylindrique (41) ;
- un arbre (42) disposé de façon symétrique dans ledit carter ;
- un appareil (43, 47a-b, 43', 43") attaché de manière fixe audit arbre et en ajustement serré avec ledit carter cylindrique, définissant ainsi des chambres séparées (44a-d) à l'intérieur du carter ;
- une pluralité de sorties ou d'entrées (46a-f) disposées de manière fixe le long de la circonférence dudit carter ; et
- une pluralité d'entrées ou de sorties disposées axialement (45a-b), chacune d'entre elles étant connectée de manière fixe à une chambre respective parmi lesdites chambres séparées, dans lequel :
- les chambres séparées et donc les entrées ou sorties disposées axialement sont alternativement en communication fluide avec chacune des sorties ou entrées disposées de manière fixe le long de la circonférence dudit carter en réponse à la rotation dudit arbre et dudit appareil par rapport audit carter,
ledit appareil comprenant un agencement de roues (47a-b, 43', 43") pour pomper un fluide à travers ledit dispositif de pompe et de vanne combinées en réponse à la rotation dudit arbre et dudit appareil.

2. Dispositif selon la revendication 1, dans lequel ledit appareil attaché de manière fixe audit arbre et en ajustement serré avec ledit carter cylindrique définit deux chambres séparées (44"'a-b, 44""a-b) à l'intérieur du carter.

3. Dispositif selon la revendication 2, dans lequel ledit appareil attaché de manière fixe audit arbre et en ajustement serré avec ledit carter cylindrique comprend un disque elliptique (43"').

4. Dispositif selon la revendication 2, dans lequel ledit appareil attaché de manière fixe audit arbre et en ajustement serré avec ledit carter cylindrique comprend un élément (43"") ayant deux parties d'extrémité (43""a-b) couvrant chacune essentiellement une moitié respective de la section transversale du carter et une partie intermédiaire séparant les deux parties d'extrémité axialement.

5. Dispositif selon la revendication 1, dans lequel ledit appareil (43, 47a-b) attaché de manière fixe audit arbre et en ajustement serré avec ledit carter cylindrique définit au moins quatre chambres séparées à l'intérieur du carter.

6. Dispositif selon la revendication 5, dans lequel ledit appareil attaché de manière fixe audit arbre et en ajustement serré avec ledit carter cylindrique comprend un élément (43) qui connecte de manière fixe chacune des au moins quatre chambres séparées alternativement à une entrée ou une sortie respective de la pluralité d'entrées ou sorties disposées axialement.

7. Dispositif selon l'une quelconque des revendications 1 à 6, dans lequel le nombre desdites entrées ou sorties disposées axialement (45a-b) est de deux.

8. Dispositif selon l'une quelconque des revendications 1 à 7, dans lequel ledit appareil comprend un élément (43) en ajustement serré avec ledit carter cylindrique, définissant ainsi lesdites chambres séparées à l'intérieur du carter, et ledit agencement de roues (47a-b) en tant que parties séparées.

9. Dispositif selon la revendication 8, dans lequel ledit agencement de roues comprend deux roues, une de chaque côté dudit élément, vu dans une direction axiale.

10. Dispositif selon l'une quelconque des revendications 1 à 9, dans lequel ledit appareil est un appareil en une pièce (43', 43 ").

11. Dispositif selon la revendication 10, dans lequel ledit appareil en une pièce comprend des surfaces (43'a, 43"a) qui ont une forme prévue pour obtenir une fonction de pompage quand ledit appareil en une pièce est mis en rotation.

12. Dispositif selon l'une quelconque des revendications 1 à 11, comprenant un moteur connecté audit arbre et prévu pour faire tourner ledit arbre et ledit appareil.

13. Système générateur pour convertir de l'énergie thermique en énergie électrique comprenant le dispositif de l'une quelconque des revendications 1 à 12.

14. Centrale électrique comprenant le système générateur de la revendication 13.

15. Utilisation du dispositif de l'une quelconque des revendications 1 à 12 dans un procédé ou système pour produire de l'énergie électrique.
